(19) Europäisches Patentamt
European Patent Office
Office européen des brevets

(11) EP 4 711 851 A1

(12) EUROPEAN PATENT APPLICATION
published in accordance with Art. 153(4) EPC

(43) Date of publication:
18.03.2026 Bulletin 2026/12

(21) Application number: 24831643.2

(22) Date of filing: 10.06.2024

(51) International Patent Classification (IPC):
G03F 7/20 (2006.01)    G21G 4/04 (2006.01)
G21K 1/00 (2026.01)    G21K 5/02 (2006.01)
H05G 2/00 (2006.01)

(52) Cooperative Patent Classification (CPC):
G03F 7/20; G21G 4/04; G21K 1/00; G21K 5/02;
H05G 2/00

(86) International application number:
PCT/JP2024/021000

(87) International publication number:
WO 2025/004773 (02.01.2025 Gazette 2025/01)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 26.06.2023 JP 2023104464
29.05.2024 JP 2024086844

(71) Applicant: Ushio Denki Kabushiki Kaisha
Minato-ku, Tokyo 1080073 (JP)

(72) Inventors:
• MIYAGAWA, Nobuaki
Tokyo 108-0073 (JP)
• TERAMOTO, Yusuke
Tokyo 108-0073 (JP)

(74) Representative: Maiwald GmbH
Engineering
Elisenhof
Elisenstrasse 3
80335 München (DE)

(54) **STORAGE DEVICE, STORAGE AMOUNT CALCULATION METHOD, AND LIGHT SOURCE DEVICE**

(57) A storage device according to an embodiment of the present technology includes: a storage unit; a first temperature sensor; a temperature adjustment mechanism; and a calculation unit. The storage unit contains contents and has a side portion. The first temperature sensor is disposed on a surface of the side portion on an outer side. The temperature adjustment mechanism is capable of maintaining a temperature of the contents contained in the storage unit at a predetermined temperature. The calculation unit calculates an amount of the contents contained in the storage unit on a basis of a temperature detected by the first temperature sensor.

FIG.3

EP 4 711 851 A1

**Description**

Technical Field

The present invention relates to a storage device, a content amount calculation method, and a light source apparatus including the storage device.

Background Art

X-rays have been conventionally used for medical, industrial and research applications. In the medical field, X-rays are used for such applications as chest radiography, dental radiography, and computed tomography (CT). In the industrial field, X-rays are used for such applications as non-destructive testing and tomographic non-destructive testing to observe the inside of materials such as structures and welds. In the research field, X-rays are used for such applications as X-ray diffraction to analyze the crystal structure of materials and X-ray spectroscopy (X-ray fluorescence analysis) to analyze the constituent composition of materials.
Extreme ultraviolet light (hereinafter, also referred to as "EUV light") having a wavelength of 13.5 nm, which is in the soft X-ray region having a relatively long wavelength among X-rays, has been recently used for exposure light. The base material of a mask for EUV lithography, the mask being provided with fine patterns, is a reflective mirror having a stacked structure, which is provided with a multilayer film (e.g., molybdenum and silicon) for reflecting EUV light on a substrate made of low-thermal-expansion glass. The EUV mask is fabricated by patterning a material that absorbs radiation having a wavelength of 13.5 nm on the multilayer film.
The size of unacceptable defects in EUV masks is much smaller than that of conventional ArF masks, making its detection difficult. Hence, EUV masks are usually inspected using radiation having a wavelength that matches the wavelength operated on lithography, which is called an actinic inspection. For example, inspection using radiation having a wavelength of 13.5 nm enables defect detection with the resolution of the wavelength or less.
EUV light source apparatuses generally include DPP (Discharge Produced Plasma) light source apparatuses, LDP (Laser Assisted Discharge Produced Plasma) light source apparatuses, and LPP (Laser Produced Plasma) light source apparatuses.
The DPP light source apparatus applies high voltage between electrodes between which a plasma raw material in the gas state (discharge gas) containing EUV radiation species is supplied to generate high-density high-temperature plasma by the discharge, utilizing the extreme ultraviolet light radiated from the plasma.
The LDP light source apparatus is an improved version of the DPP light source apparatus. In the DPP light source apparatus, for example, a liquid high-temperature plasma raw material (e.g., Sn (tin) or Li (lithium)) containing EUV radiation species is supplied to the surface of the electrode (discharge electrode) at which the discharge occurs. The raw material is then irradicated with an energy beam (e.g., an electron beam or a laser beam) to vaporize the raw material, and then high-temperature plasma is generated by discharge.
The LPP light source apparatus generates high-temperature plasma by exciting the EUV radiation species with a laser beam or the like. As the light source apparatus using this method, those focusing a laser beam on a droplet that has been ejected in the form of a minute liquid droplet, which is the target material for EUV radiation, to excite the target material thereby generating plasma have been known. The droplet is made of materials such as tin (Sn) and lithium (Li).
Patent Literature 1 proposes a method of generating radiation by supplying a plasma raw material for generating radiation such as X-rays and EUV to a rotation body and applying an energy beam (laser beam) to a region to be supplied with the plasma raw material in the rotation body. A cylindrical container with one opened end is used as the rotation body, a liquid plasma raw material is supplied to this container, and the laser beam is applied onto the inner peripheral surface of the container.
This method corresponds to a so-called LPP method, but the liquid plasma raw material is supplied to the irradiation region of the energy beam using the centrifugal force of the rotation body, eliminating the need to supply the liquid plasma raw material as droplets. For this reason, it is possible to obtain high-luminance radiation with a relatively simple configuration, as compared with a method of focusing a laser beam onto droplets, and the like.

Citation List

Patent Literature

Patent Literature 1: Japanese Patent Application Laid-open No. 2014-216286

Disclosure of Invention

Technical Problem

In the light source apparatuses such as those described in Patent Literature 1, there is a demand for a technology that accurately calculates the amount of the contents such as a raw material contained in a container.

In view of the circumstances as described above, it is an object of the present invention to provide a storage device, a content amount calculation method, and a light source apparatus that are capable of accurately calculating the amount of the contents contained in a container.

Solution to Problem

In order to achieve the above-mentioned object, a storage device according to an embodiment of the present technology includes: a storage unit; a first temperature sensor; a temperature adjustment mechanism; and a calculation unit.

The storage unit contains contents and has a side portion.

The first temperature sensor is disposed on a surface of the side portion on an outer side.

The temperature adjustment mechanism is capable of maintaining a temperature of the contents contained in the storage unit at a predetermined temperature.

The calculation unit calculates an amount of the contents contained in the storage unit on the basis of a temperature detected by the first temperature sensor.

In this storage device, the first temperature sensor is disposed on the surface of the side portion of the storage unit on the outer side, and the amount of the contents contained in the storage unit is calculated on the basis of the temperature detected by the first temperature sensor. This allows the amount of the contents contained in the storage unit to be accurately calculated.

The calculation unit may calculate the amount of the contents on the basis of a difference between a predetermined initial temperature and the temperature detected by the first temperature sensor.

The calculation unit may calculate the amount of the contents using the following formula.

[Math. 1]

$$ V = k \left( T_x - T_0 \right) $$

V:    the amount of the contents
k:    a predetermined coefficient
$T_x$:    the temperature detected by the first temperature sensor
$T_0$:    the predetermined initial temperature

The $T_0$ may have a value of 100°C or more.

A difference between a value of the $T_x$ and a value of the $T_0$ may be 100°C or less.

The calculation unit may calculate the amount of the contents on the basis of the temperature detected by the first temperature sensor and a predetermined correspondence between a temperature and the amount of the contents.

The calculation unit may calculate a height of a surface of the contents contained in the storage unit.

The first temperature sensor may be disposed above the temperature adjustment mechanism.

The first temperature sensor may be disposed above a center of the storage unit.

The first temperature sensor may be disposed at an upper end of the side portion of the storage unit.

The temperature adjustment mechanism may be disposed below a center of the storage unit.

The storage unit may have a bottom portion. In this case, the temperature adjustment mechanism may be disposed at the bottom portion of the storage unit.

A rotation body may be immersed in the contents contained in the storage unit.

The storage unit may be provided with a supply port for supplying the contents to the storage unit. In this case, the first temperature sensor may be disposed at a same height as or above the supply port.

The storage unit may be provided with a supply port for supplying the contents to the storage unit. In this case, the temperature adjustment mechanism may be disposed at a same height as or below the supply port.

The first temperature sensor may include a plurality of first temperature sensors.

The temperature adjustment mechanism may include a heating mechanism that heats the contents contained in the storage unit and a second temperature sensor. In this case, the heating mechanism may maintain the temperature of the contents at a predetermined temperature by heating the contents on the basis of a temperature detected by the second temperature sensor.

The second temperature sensor may be disposed above the heating mechanism.

A first pipe for causing the contents to flow from an outside thereinto and a second pipe for causing the contents to flow out to the outside may be connected to the storage unit, and a third pipe for supplying the contents to the storage unit may be inserted into the storage unit from above.

The third pipe may include a valve that controls movement of the contents. In this case, another storage unit may be connected to the third pipe.

At least one of the first pipe, the second pipe, or the third pipe may include a pump for causing the contents to move.

The side portion may be formed of ceramics, stainless steel, or silicon.

The side portion may have a thickness of 1 mm or more and 20 mm or less.

The side portion may have a thermal conductivity of 10W/(m×k) or more and 200 W/(m×k) or less at 300 K.

The side portion may include a first member and a second member having a thermal conductivity higher than that of the first member. In this case, the first temperature sensor may be disposed in the second member.

The side portion may have a double structure including an outer member, an inner member, and an internal space formed between the outer member and the inner member.

The internal space may communicate with an inside of the storage unit at its top.

The contents may include a liquid raw material.

The liquid raw material may be tin, lithium, gadolinium, gallium, bismuth, indium, or an alloy including at least one of these materials.

The contents may include a powder raw material.

A content amount calculation method according to an embodiment of the present technology includes: calculating, in a storage device that includes a storage unit that contains contents and has a side portion, a first temperature sensor that is disposed on a surface of the side portion on an outer side, and a temperature adjustment mechanism that is capable of maintaining a temperature of the contents contained in the storage unit at a predetermined temperature, the amount of the contents contained in the storage unit on the basis of a temperature detected by the first temperature sensor.

By the first temperature sensor, the temperature may be detected while a flow of the contents inside the storage unit is stopped.

A light source apparatus according to an embodiment of the present technology is a light source apparatus that generates radiation by converting a raw material into plasma utilizing application of an energy beam, including: a storage unit that contains the raw material and has a side portion; a first temperature sensor that is disposed on a surface of the side portion on an outer side; a temperature adjustment mechanism that is capable of maintaining a temperature of the raw material contained in the storage unit at a predetermined temperature; and a calculation unit that calculates an amount of the raw material contained in the storage unit on the basis of a temperature detected by the first temperature sensor.

Advantageous Effects of Invention

According to the present invention, it is possible to accurately calculate the amount of the contents such as a raw material contained in a container. It should be noted that the effects described here are not necessarily limitative, and any of the effects described in the present disclosure may be provided.

Brief Description of Drawings

[Fig. 1] Fig. 1 is a schematic diagram illustrating a configuration example of a light source apparatus according to a first embodiment of the present invention.

[Fig. 2] Fig. 2 is a schematic diagram illustrating a configuration example of a plasma generation mechanism, ac, and a storage section.

[Fig. 3] Fig. 3 is a cross-sectional view illustrating a configuration example of the storage section.

[Fig. 4] Fig. 4 is a schematic diagram illustrating an experimental storage section.

[Fig. 5] Fig. 5 is a graph showing a relationship between the amount of a plasma raw material and the temperature detected by a temperature sensor.

[Fig. 6] Fig. 6 is a schematic diagram illustrating a configuration example of a storage section having a double structure.

[Fig. 7] Fig. 7 is a schematic diagram illustrating a configuration example of the storage section having a double structure.

[Fig. 8] Fig. 8 is a schematic diagram illustrating a configuration example of the plasma generation mechanism.

[Fig. 9] Fig. 9 is a schematic diagram illustrating variations in the disposition of a temperature sensor and a heater.

[Fig. 10] Fig. 10 is a schematic diagram illustrating variations in the disposition of the temperature sensor and the heater.

[Fig. 11] Fig. 11 is a schematic diagram illustrating a configuration example of the raw material supply device.

[Fig. 12] Fig. 12 is a schematic diagram illustrating a configuration example of a plasma generation mechanism capable of recycling the plasma raw material.

Mode(s) for Carrying Out the Invention

Hereinafter, embodiments according to the present technology will be described with reference to the drawings.

<First embodiment>

[Basic configuration of light source apparatus]

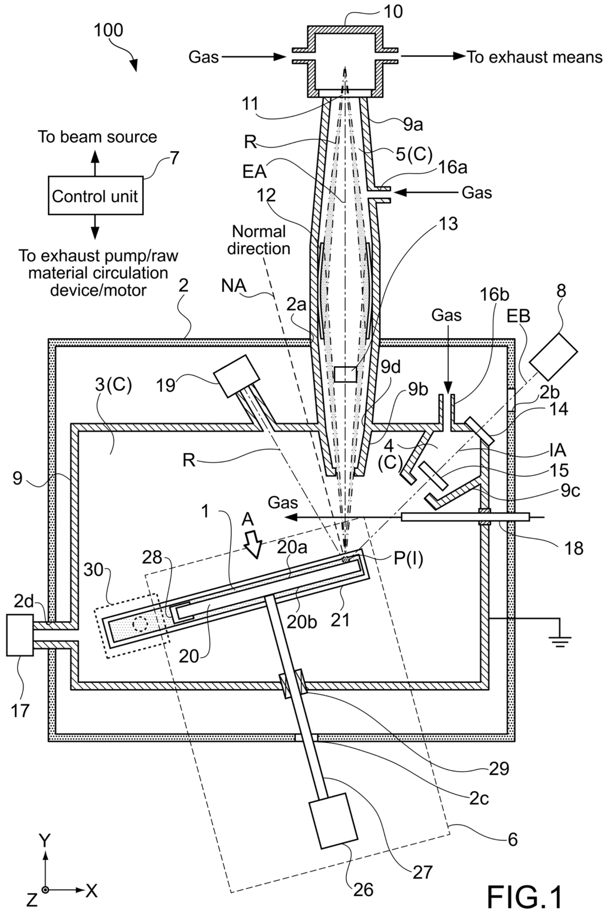

Fig. 1 is a schematic diagram illustrating a configuration example of a light source apparatus according to a first embodiment of the present invention.

A light source apparatus 100 is an LPP-based light source apparatus. That is, the light source apparatus 100 is a light source apparatus that extracts radiation R by converting a plasma raw material 1 into plasma utilizing application of an energy beam EB.

Note that in the present disclosure, the radiation R includes light (electromagnetic waves) radiated from the plasma P, such as light in a soft X-ray region, such as EUV light, and hard X-rays having a higher energy.

In the case where EUV light is emitted as the radiation R, an EUV raw material is used as the plasma raw material 1. Examples of the raw material that emits EUV light include tin (Sn) and lithium (Li) in the form of liquid. Although Sn and Li are solid at room temperature, they are used in the liquid state in the case where they are irradiated with the energy beam EB.

In the case where X-rays are emitted as the radiation R, an X-ray raw material is used as the plasma raw material 1. The X-ray raw material is, for example, a metal in a liquid state at room temperature. For example, gallium (Ga), a gallium alloy, or an Sn compound can be used as the X-ray raw material.

The plasma raw material 1 corresponds to an embodiment of contents and a liquid raw material according to the present technology.

Fig. 1 illustrates a schematic cross section of the light source apparatus 100 when the light source apparatus 100 is cut along the horizontal direction at a predetermined height from its installation surface and viewed from above.

In Fig. 1, the illustration of the cross section is omitted for portions for which the configuration of the cross section does not need to be explained, in order to facilitate the understanding of the configuration and operation of the light source apparatus 100.

In the following description, the X direction will be referred to as a right-and-left direction (the positive side of the X axis is the right side, and the negative side is the left side), the Y direction will be referred to as a front-and-rear direction (the positive side of the Y axis is the front side, and the negative side is the rear side), and the Z direction will be referred to as a height direction (the positive side of the Z axis is the upper side, and the negative side is the lower side) in some cases. It goes without saying that in the application of the present technology, the orientation in which the light source apparatus 100 is used, and the like are not limited.

The light source apparatus 100 includes an enclosure 2, a vacuum chamber 3, an energy beam incident chamber 4, a radiation emission chamber 5, a plasma generation mechanism 6, a control unit 7, and a raw material supply device 30. Note that in Fig 1, the raw material supply device 30 is schematically illustrated by a broken-line frame.

In the example shown in Fig. 1, the enclosure 2 is configured such that its external shape is approximately a cube. Note that the shape of the enclosure 2 is not limited to a cube and may be an arbitrary three-dimensional shape.

The enclosure 2 includes an emission hole 2a formed in the front face of the enclosure 2, an incident hole 2b formed in the right side face thereof, a through-hole 2c formed in the rear face thereof, and a through-hole 2d formed in the left side face thereof.

The material of the enclosure 2 is not limited. For example, an enclosure made of metal is used as the enclosure 2.

In this embodiment, the radiation R is set to allow an emission axis EA to pass through the emission hole 2a in the front face and extend in the Y direction (front-rear direction). The radiation R such as X-rays and EUV light is extracted along the emission axis EA and emitted through the emission hole 2a toward the front side.

Further, in this embodiment, the energy beam EB is set to allow an incident axis IA to extend from the incident hole 2b on the right side face toward the rear side at an oblique angle to the left.

As shown in Fig. 1, a beam source 8 that emits the energy beam EB is disposed outside the enclosure 2. The beam source 8 is disposed to allow the energy beam EB to enter the inside of the enclosure 2 along the incident axis IA.

Examples of the energy beam EB include an electron beam and a laser beam. The beam source 8 can be configured to employ any configurations capable of emitting these energy beams EB.

The light source apparatus 100 is provided with a chamber section C that includes a plurality of chambers. Specifically, the chamber section C includes the vacuum chamber 3, the energy beam incident chamber (hereinafter, simply referred to as the "incident chamber") 4, and the radiation emission chamber (hereinafter, simply referred to as the "emission chamber") 5. The vacuum chamber 3, the incident chamber 4, and the emission chamber 5 are spatially communicated with each other. In other words, the vacuum chamber 3 and the incident chamber 4 are connected to each other. Similarly, the vacuum chamber 3 and the emission chamber 5 are connected to each other.

The incident chamber 4 is formed to be located on the incident axis IA of the energy beam EB, and the emission chamber 5 is formed to be located on the emission axis EA of the radiation R. Further, the vacuum chamber 3 is provided with a mechanism that generates the plasma P.

In this embodiment, the chamber section C (the vacuum chamber 3, the incident chamber 4, and the emission chamber 5) includes a chamber body 9, an outer protrusion 9a protruding from the front face of the chamber body 9 toward the front side, and two inner protrusions 9b and 9c protruding inward from the inner circumferential face of the chamber body 9.

The chamber body 9, the outer protrusion 9a, and the two inner protrusions 9b and 9c, which constitute the chamber section C, are made of metal materials.

The chamber body 9 is configured such that its external shape is approximately a rectangular parallelepiped shape, and has its front, rear, left, and right faces that are arranged to face the front, rear, left, and right faces of the enclosure 2, respectively.

The chamber body 9 has a right-front corner that is disposed to be on the incident axis IA of the energy beam EB, the right-front corner being located between the front face and the right side face.

As shown in Fig. 1, an emission hole 9d is formed in the front face of the chamber body 9. The emission hole 9d is formed along the emission axis EA of the radiation R and in line with the emission hole 2a in the front face of the enclosure 2.

The outer protrusion 9a is configured to protrude from the circumferential edge portion of the emission hole 9d in the chamber body 9. The outer protrusion 9a is configured to protrude more forward than the emission hole 2a of the enclosure 2 with being inscribed in the emission hole 2a of the enclosure 2.

An inner protrusion 9b is configured to protrude inward from the circumferential edge portion of the emission hole 9d inside the chamber body 9. Note that the configuration of the inner protrusion 9b is not essential, and only the outer protrusion 9a may be provided to the chamber section C.

The space surrounded by the outer protrusion 9a and the inner protrusion 9b serves as the emission chamber 5. The outer protrusion 9a and the inner protrusion 9b themselves, which are the components constituting the emission chamber 5, can also be referred to as the emission chamber.

The outer protrusion 9a and the inner protrusion 9b may be integrally formed with the chamber body 9, or they may be formed separately and then connected to the chamber body 9.

The emission chamber 5 is configured to have a cone shape with its central axis being aligned with the emission axis EA of the radiation R. The emission chamber 5 is configured to have a large cross-sectional area at its center portion in the direction of the emission axis EA of the radiation R, and have the cross-sectional area being decreased toward the front and rear ends. In other words, the emission chamber 5 is shaped to taper toward the front and rear ends. Further, the emission chamber 5 is provided with an opening (aperture) that allows the radiation R to pass therethrough at its front and rear ends.

A utilization device such as a mask inspection device is connected to the end of the emission chamber 5 on the front side (end of the outer protrusion 9a on the front side). In the example shown in Fig. 1, an application chamber 10 is connected as a chamber constituting part of the utilization device. The pressure inside the application chamber 10 may be an atmospheric pressure. Further, a gas (e.g., an inert gas) may be introduced from a gas injection path into the inside of the application chamber 10 as necessary and purged. Further, the gas inside the application chamber 10 may be exhausted by an exhaust means (not shown).

A filter film 11 for physically separating a region where the plasma P is generated and the application chamber 10 is provided between the emission chamber 5 and the application chamber 10. The filter film 11 is formed to have a structure that allows radiation to be transmitted therethrough and prevents the plasma raw material 1 and debris scattered during the generation of the plasma P from entering the application chamber 10.

A collector (focusing mirror) 12 for guiding and focusing the radiation R that has entered the emission chamber 5 into the utilization device (inside the application chamber 10) is disposed inside the emission chamber 5. In Fig. 1, the components of the radiation R that enters the emission chamber 5 and is focused is illustrated in hatching.

A shielding member (central occultation) 13 is disposed inside the emission chamber 5. The shielding member 13 is located in line with the emission hole 9d of the chamber body 9, the emission hole 2a of the enclosure 2, and the filter film 11 along the emission axis EA of the radiation R. In this embodiment, the shielding member 13 can block the radiation components that are not focused by the collector 12. Note that the shielding member 13 does not necessarily need to be provided.

A incident window 14 is formed in the right-front corner of the chamber body 9. The incident window 14 is formed along the incident axis IA of the energy beam EB and in line with the incident hole 2b in the right side face of the enclosure 2.

An inner protrusion 9c is configured to protrude inside the right-front corner of the chamber body 9 along the incident axis IA of the energy beam EB from a position surrounding the incident window 14.

In the internal space of the chamber body 9, the space surrounded by the inner protrusion 9c serves as the incident chamber 4. The inner protrusion 9c and the right-front corner of the chamber body 9 themselves, which are the components constituting the incident chamber 4, can also be referred to as the incident chamber.

The inner protrusion 9c may be formed integrally with the chamber body 9, or it may be formed separately and then connected to the chamber body 9.

The incident chamber 4 is configured to have a cone shape with its central axis being aligned with the incident axis IA of the energy beam EB. The incident chamber 4 is configured to have a cross-sectional area being decreased toward its end inside the chamber body 9 in the direction of the incident axis IA of the energy beam EB. That is, the incident chamber 4 has a shape that tapers toward the end thereinside. The incident chamber 4 is provided with an opening (aperture) through which the energy beam EB passes at the end thereinside.

A capturing mechanism is disposed to capture the scattered plasma raw material 1 and debris inside the incident chamber 4. In the example shown in Fig. 1, as a capturing mechanism, a rotary window 15, which is a plate-shaped rotation member that allows the energy beam EB to be transmitted therethrough and captures the plasma raw material 1 and debris, is disposed. Causing the rotary window 15 to rotate makes it possible to increase the substantial area of the beam transmission area of the rotary window 15 and reduce the frequency of replacement of the rotary window 15.

As shown in Fig. 1, gas injection channels 16a and 16b are respectively provided in the emission chamber 5 and the incident chamber 4, and gas is supplied to the emission chamber 5 and the incident chamber 4 from a gas supply device, which is omitted in the figure. A gas that has high transmittance to the radiation R is supplied to the emission chamber 5. A gas that has high transmittance to the energy beam EB is supplied to the incident chamber 4.

The gasses to be supplied to the emission chamber 5 and the incident chamber 4 may be the same type of gas or different type of gasses. For example, argon or helium can be used as a gas that has high transmittance to both the energy beam EB and the radiation R. In addition, the type of gas to be supplied to the emission chamber 5 and the incident chamber 4 is not limited.

By supplying gas, it is possible to set the pressure inside the emission chamber 5 and the incident chamber 4 to a pressure higher than the pressure inside the vacuum chamber 3, and prevent debris and the like from entering.

In the internal space of the chamber body 9, the space excluding the internal space of the inner protrusion 9b, which serves as the emission chamber 5, and the internal space of the inner protrusion 9c, which serves as the incident chamber 4, serves as the vacuum chamber 3. The components themselves constituting the vacuum chamber 3 can also be referred to as the vacuum chamber.

As shown in Fig. 1, the chamber body 9 has a portion that protrudes through the through-hole 2d in the left side face of the enclosure 2 to the outside of the enclosure 2, and the portion has an end connected to an exhaust pump 17. The specific configuration of the exhaust pump 17 is not limited, and an arbitrary pump such as a vacuum pump may be used.

The exhaust pump 17 exhausts the inside of the vacuum chamber 3 and depressurizes the vacuum chamber 3. This suppresses the attenuation of the radiation R generated in the vacuum chamber 3.

The inside of the vacuum chamber 3 is not necessarily a vacuum atmosphere, provided that it is a reduced-pressure atmosphere with respect to the incident chamber 4 and the emission chamber 5. The inside of the vacuum chamber 3 may be supplied with an inert gas.

In this embodiment, a gas nozzle 18 is disposed to extend in the left-right direction toward the region between the incident axis IA and the emission axis EA. The gas nozzle 18 is disposed on the right side face of the chamber body 9 via a seal member or the like. The gas nozzle 18 is connected to a gas supply device, which is omitted in the figure, and supplies gas to the inside of the chamber body 9. Note that the configuration of the gas nozzle 18 is not essential, and the gas may be supplied without using gas nozzle.

In the example shown in Fig. 1, the gas nozzle 18 ejects gas from the right side of the region between the incident axis IA and the emission axis EA toward the left side thereof in the left-right direction. This allows the debris that has been released from the plasma P to move in a direction away from the incident axis IA and the emission axis EA.

The plasma generation mechanism 6 is a mechanism for generating the plasma P inside the vacuum chamber 3 and emitting the radiation R (X-rays, EUV light).

The plasma generation mechanism 6 includes a disk-shaped rotation body 20 for supplying raw materials, and a raw material container 21 that contains the liquid plasma raw material 1. The rotation body 20 and the raw material container 21 are disposed inside the vacuum chamber 3.

As shown in Fig. 1, the energy beam EB enters the disk-shaped rotation body 20. The rotation body 20 is disposed inside the vacuum chamber 3 such that an irradiation position I of the energy beam EB is located at the intersection of the incident axis IA and the emission axis EA. Note that the shape of the rotation body is not limited to the disk shape. For example, a polygonal rotation body or the like may be used.

The raw material container 21 is provided such that the rotation body 20 is immersed therein, and supplies the liquid plasma raw material 1 to the rotation body 20. For example, the rotation body 20 is rotatably held while being immersed in the liquid plasma raw material 1 inside the raw material container 21, and the plasma raw material 1 adheres to the front surface of the rotation body 20. When the rotation body 20 in this state, the plasma raw material 1 is supplied to the irradiation position I of the rotation body 20. When the irradiation position I of the rotation body 20 is irradiated with the energy beam EB, the plasma P is generated.

As described above, the raw material container 21 is provided inside the vacuum chamber 3, stores the liquid plasma raw material 1, and supplies the liquid plasma raw material 1 to the irradiation position I of the energy beam EB. In addition, the configuration of the plasma generation mechanism 6 will be described below in detail.

The control unit 7 controls the operation of each component provided in the light source apparatus 100.

For example, the control unit 7 controls the operation of the beam source 8 and the exhaust pump 17. In addition, the control unit 7 controls the operation of various motors, the raw material supply device 30, and the like, which will be described below.

The control unit 7 includes hardware circuits necessary for computers, such as CPUs and memories (RAM, ROM). A CPU loads a control program stored in a memory into a RAM and executes it to perform various processes.

As the control unit 7, a programmable logic device (PLD) such as field programmable gate array (FPGA), and other devices such as application specific integrated circuit (ASIC) may be used.

In Fig. 1, the control unit 7 is schematically illustrated as a functional block. However, the control unit 7 may be designed in any desired manner including the position at which the control unit 7 is configured.

Further, as shown in Fig. 1, in this embodiment, a radiation diagnosis section 19 is formed in the area spatially connected to the vacuum chamber 3 on the front face side of the chamber body 9. The radiation diagnosis section 19 is disposed at a position at which the radiation R radiated in a direction different from the emission axis EA of the radiation R is incident.

The radiation diagnosis section 19 measures the state of the radiation R emitted from the plasma P. Here, the state of the radiation R means the physical state of the radiation R, such as intensity, wavelength, and spectrum of the radiation R. The radiation diagnosis section 19 includes a detector that detects the presence or absence of the radiation R and a measurement device that measures the output of the radiation R, for example.

The measurement results with the radiation diagnosis section 19 are used to diagnose the radiation R or to control the operation of the raw material supply device 30 described below.

The raw material supply device 30 supplies the plasma raw material 1 into a raw material container 21. The timing of supplying the plasma raw material 1 by the raw material supply device 30, and the like are not limited. The specific configuration of the raw material supply device 30 will be described below in detail.

[Plasma generation mechanism, etc.]

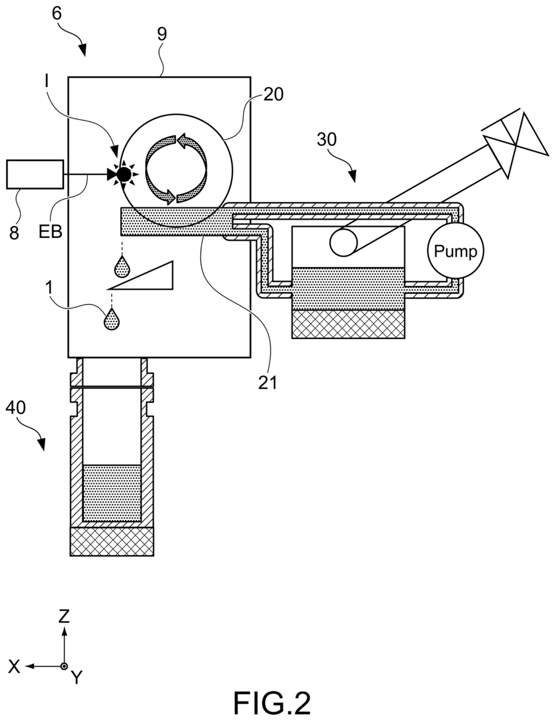

Fig. 2 is a schematic diagram illustrating a configuration example of the plasma generation mechanism 6, the raw material supply device 30, and the storage section 40. Fig. 2 shows the plasma generation mechanism 6 in Fig. 1 as viewed from the direction indicated by an arrow A (positive side of the Y direction). The raw material supply device 30 and the storage section 40 are connected to the plasma generation mechanism 6. Note that in Fig. 1, the raw material supply device 30 is illustrated by a broken line frame and illustration of the storage section 40 is omitted.

As shown in Fig. 2, the raw material supply device 30 includes a container that contains the plasma raw material 1, a pipe connected to the container, a pump provided to the pipe, a pipe inserted into the container from above, and the like. Further, the pipe connected to the container is connected to the raw material container 21 of the plasma generation mechanism 6. This allows the plasma raw material 1 to be supplied to the raw material container 21.

Since the rotation body 20 is immersed in the plasma raw material 1 in the raw material container 21, the plasma raw material 1 is lifted while adhering to the rotation body 20 by the rotation of the rotation body 20. Further, the energy beam EB is applied to the adhered plasma raw material 1 by the beam source 8. In Fig. 2, the energy beam EB is schematically illustrated by an arrow.

At the irradiation position I, part of the plasma raw material 1 is not converted into plasma and scatters in some cases. The scattered plasma raw material 1 falls down below the raw material container 21, as shown in Fig. 2. The storage section 40 is connected to the lower side of the plasma generation mechanism 6, and the fallen plasma raw material 1 accumulates in the storage section 40. Further, the plasma raw material 1 leaks from the raw material container 21 in some cases, and such plasma raw material 1 also accumulates in the storage section 40.

[Storage section]

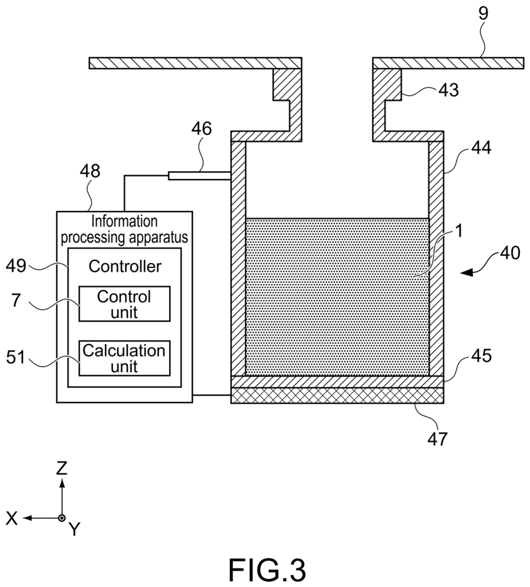

Fig. 3 is a cross-sectional view illustrating a configuration example of the storage section 40. The storage section 40 is a substantially cylindrical container. Fig. 3 shows the cross section of the storage section 40 cut through its center by the XZ plane. Furter, the state where the plasma raw material 1 is stored in the storage section 40 is shown. The storage section 40 includes an upper portion 43, a side portion 44, and a bottom portion 45.

The upper portion 43 has a disc shape and has an opening protruding to the positive side of the Z direction at its center. An opening having the same shape is also formed in the chamber body 9, and the upper portion 43 is connected to the chamber body 9 such that the opening of the chamber body 9 and the opening of the upper portion 43 match. The diameter of each opening and the specific connection form between the upper portion 43 and the chamber body 9 are not limited.

The side portion 44 has a cylindrical shape. The diameter of the side portion 44 is the same as the diameter of the upper portion 43, and the upper end of the side portion 44 is connected to the lower surface of the upper portion 43. The bottom portion 45 has a disc shape. The diameter of the bottom portion 45 is the same as the diameter of the side portion 44, and the upper surface of the bottom portion 45 is connected to the lower end of the side portion 44. In addition, the specific shape of the storage section 40 is not limited. For example, any shape realizable within the scope of the present technology, such as a spherical shape and a prismatic shape, may be adopted.

The storage section 40 corresponds to an embodiment of the storage unit according to the present technology.

In this embodiment, a temperature sensor 46, a heater 47, and an information processing apparatus 48 are connected to the storage section 40. The temperature sensor 46 is, for example, a sensor such as a thermocouple and a platinum resistance thermometer (PT100). It goes without saying that the specific type of the temperature sensor 46 is not limited. Although the temperature sensor 46 is schematically illustrated as rod-shaped in Fig. 3, the specific shape of the temperature sensor 46 is also not limited.

The temperature sensor 46 is disposed on the surface of the side portion 44 on the outer side. The inside of the storage section 40 is a space where the plasma raw material 1 is contained, and the outside of the storage section 40 is a space on the side opposite thereto. As shown in Fig. 3, the temperature sensor 46 is disposed to abut on the surface of the side portion 44 on the outer side (left side).

Further, in this example, the temperature sensor 46 is disposed above the center of the storage section 40. The center refers to the center of the side portion 44 in the Z direction (in the up-and-down direction), and the temperature sensor 46 is disposed above this. Alternatively, the center may refer to the center in the up-and-down direction when the side portion 44 and the upper portion 43 are viewed together. In this case as well, the temperature sensor 46 is disposed above the center. It goes without saying that the present technology is not limited thereto. The temperature sensor 46 may be disposed below the center, and the specific disposition location is not limited.

The temperature sensor 46 corresponds to an embodiment of the first temperature sensor according to the present technology.

The heater 47 is, for example, a resistance heating electric heater. Other arbitrary heating mechanisms such as a heating device utilizing induction heating (IH), an infrared lamp such as a halogen lamp, and a heating medium oil circulation device may be used.

In this example, the heater 47 has a rod shape and is disposed on the bottom portion 45 of the storage section 40. Specifically, a plurality of heaters 47 is arranged along the Y direction (depth direction) so as to extend in the X direction (right-and-left direction) and disposed to abut on the lower surface of the bottom portion 45. It goes without saying that the specific shape and arrangement of the heater 47 are not limited thereto. For example, the heater 47 may have a disc shape and abut on the entire lower surface of the bottom portion 45.

In the case where the temperature of the plasma raw material 1 in the storage section 40 is low, the plasma raw material 1 solidifies and grow like stalactites, interfering with the operation of the light source apparatus 100 in some cases. For this reason, the plasma raw material 1 needs to be constantly in a liquid phase.

The liquid surface of the plasma raw material 1 is in contact with the space within the storage section 40, and the pressure in this space is low, i.e., several Pa during the operation. For this reason, the conductive heat flow is small. However, thermal energy is released by radiation, and the temperature of the plasma raw material 1 decreases by the amount corresponding to the released thermal energy. Further, the amount of thermal energy by radiation is small in the side portion 44. However, since the plasma raw material 1 and the side portion 44 are in contact with each other, heat flow occurs in the side portion 44, heat conduction is caused, and the temperature of the plasma raw material 1 decreases.

For this reason, as in this embodiment, it is necessary to heat the plasma raw material 1 by the heater 47.

The heater 47 corresponds to an embodiment of the temperature adjustment mechanism according to this embodiment.

The information processing apparatus 48 is, for example, a computer such as a personal computer (PC). Other arbitrary computers may be used. The information processing apparatus 48 includes a central processing unit (CPU), a read only memory (ROM), a random access memory (RAM), a storage unit, and the like.

The information processing apparatus 48 includes a controller 49. The controller 49 includes, for example, a hardware circuit necessary for a computer, such as a CPU and a memory (RAM, ROM). The CPU executes the program according to the present technology stored in the storage unit or the memory, thereby executing various processes according to the present technology. As the controller 49, for example, a device such as a programmable logic device (PLD) such as a field programmable gate array (FPGA), and an application specific integrated circuit (ASIC) is used.

In this embodiment, the CPU of the controller 49 executes the program (e.g., application program) according to the present technology, thereby realizing the control unit 7 and a calculation unit 51 as functional blocks. These functional blocks execute the content amount calculation method according to this embodiment. Note that in order to realize each functional block, dedicated hardware such as an integrated circuit (IC) may be used as appropriate.

The control unit 7 controls the operations of the temperature sensor 46 and the heater 47. For example, the control unit 7 controls the presence or absence of heating by the heater 47 and the output of the heating. In this embodiment, the control unit 7 executes control such that the heater 47 heats at a constant output. This maintains the temperature of the plasma raw material 1 contained in the storage section 40 at a predetermined temperature. In addition, the control unit 7 may be capable of controlling the operation of an arbitrary mechanism. The calculation unit 51 calculates the amount of the plasma raw material 1 contained in the storage section 40. The content of the specific control by the control unit 7 and the specific calculation method will be described below.

Further, the information processing apparatus 48 includes a communication unit (not shown). The communication unit is, for example, a communication module for communicating with another device via a network such as a local area network (LAN) and a wide area network (WAN). A communication module for short-range wireless communication such as Bluetooth (registered trademark) may be provided. Further, a communication device such as a modem and a router may be used. This realizes communication between the information processing apparatus 48 and the temperature sensor 46 and between the information processing apparatus 48 and the heater 47, and enables control of various mechanisms and acquisition of information. Note that wired communication may also be performed. In addition, the specific configuration of the information processing apparatus 48 is not limited.

The storage section 40, the temperature sensor 46, the heater 47, and the calculation unit 51 correspond to an embodiment of a storage device according to the present technology.

[Calculation unit]

The specific content of the calculation by the calculation unit 51 will be described below. In this example, first, the temperature sensor 46 detects a temperature. Specifically, since the temperature sensor 46 is disposed on the side portion 44, the temperature of the disposition portion of the side portion 44 is detected. Since the heat of the heater 47 and the heat of the plasma raw material 1 are conducted to the side portion 44, the detected temperature varies depending on the states of the heater 47 and the plasma raw material 1.

Here, the side portion 44 has a structure in which heat is conducted relatively in one direction (upward direction), and heat flow energy of Q per unit area is generated from the plasma raw material 1 in the storage section 40 or the bottom portion 45, and heat conduction is caused in this one direction. At this time, a temperature gradient $T_x - T_0$ occurs in the plasma raw material 1. For example, in the case where the liquid surface of the plasma raw material 1 is on the lower side, the temperature sensor 46 becomes distance from the liquid surface. For this reason, the temperature detected by the temperature sensor 46 is significantly lower than the temperature of the plasma raw material 1. Meanwhile, in the case where the liquid surface is on the upper side, the temperature sensor 46 is closer to the liquid surface, and the detected temperature is not so lower than the temperature of the plasma raw material 1.

In this way, the detected temperature changes depending on the liquid level height. However, it is known that since the thermal conductivity varies depending on the temperature, the temperature gradient generally does not become linear.

Here, the present inventors have found that when $T_0$ is high to some extent and the temperature gradient between $T_0$ and $T_x$ is small, the change in thermal conductivity is small and thus, the heat changes substantially linearly with respect to the conduction direction. This allows the amount of the plasma raw material 1 to be calculated on the basis of the slope of this system and the measurement value of the temperature sensor 46.

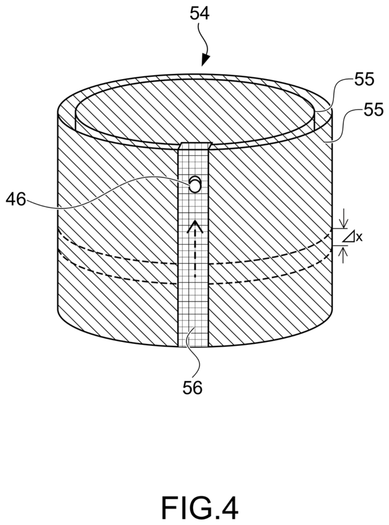

In order to verify the above idea, the present inventors prepared an experimental storage section 54. Fig. 4 is a schematic diagram illustrating the experimental storage section 54. The storage section 54 is a cylindrical container, and most of the side portion is a side portion 55 having a double structure of thin stainless steel. The upper portion of the double structure of the side portion 55 is open, and the inside of the double structure communicates with the inside of the chamber body 9. This allows the inside of the double structure to be a vacuum during operation. Further, part of the side portion extends in the up-and-down direction to form a side portion 56 having a normal structure of stainless steel (structure that is not a double structure). The temperature sensor 46 is disposed above the center of the side portion 56. Further, although not shown, the heater 47 is disposed at the bottom portion of the storage section 54.

In Fig. 4, the liquid surface is schematically illustrated by a broken line. In the experiment, first, the detection temperature by the temperature sensor 46 at a predetermined initial liquid level height (lower broken line) was measured as a predetermined initial temperature. Further, the amount (volume) of the plasma raw material 1 was calculated as an initial amount on the basis of the liquid level height and the shape of the storage section 54, and the initial amount and the initial temperature were recorded.

Further, the liquid level height was varied, a detection temperature at a liquid level height $\Delta x$ (upper broken line) was measured, and the relationship between the amount calculated from the liquid level height and the temperature were recorded for each temperature.

Specifically, the plasma raw material 1 was heated in a container within another chamber connected to the storage section 54, and then, the container was tilted to add the plasma raw material 1 dropwise into the storage section 54. Further, by breaking the vacuum once, removing the container in the atmosphere, and measuring the distance between the surface position of the container upper surface and the liquid surface of the plasma raw material 1, the amount of the plasma raw material 1 in the storage section 54 was calculated.

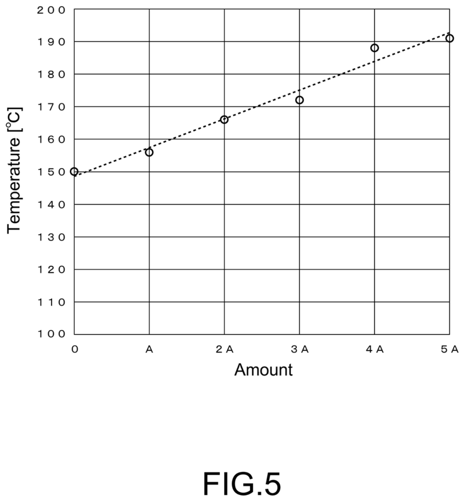

Fig. 5 is a graph showing the relationship between the amount of the plasma raw material 1 and the temperature detected by the temperature sensor 46. Fig. 5 shows the results of the experiment using the storage section 54. The horizontal axis indicates the amount of the plasma raw material 1 (A is a unit volume), and the vertical axis indicates the detection temperature by the temperature sensor 46.

As shown in Fig. 5, the detection temperature at a predetermined initial amount (0) is approximately 150°C. Further, the detection temperature at an amount A is approximately 156°C. Further, the detection temperature at an amount 5A is approximately 190°C. Note that the amount 5A is the amount of the plasma raw material 1 in the case where the liquid surface has reached the height of the temperature sensor 46. Further, although not shown, even in the case where the liquid level height is 5A or more, the detection temperature dose not rise above 190°C. This is because the plasma raw material 1 is constantly present at the position of the temperature sensor 46 and no temperature gradient occurs.

In this way, the relationship between the amount and the detection temperature is substantially linear (straight line indicated by a broken line) although some variation exists. That is, the following relationship is established.

[Math. 1]

$$V = k \left( T_x - T_0 \right)$$

V:    the amount of the plasma raw material 1
k:    a predetermined coefficient
$T_x$:    the temperature detected by the temperature sensor 46
$T_0$:    the predetermined initial temperature

In this example, the initial temperature $T_0$ is 150°C. Further, since the detection temperature at the amount V = 5A is Tx=190°C, the coefficient k can be obtained by substituting these. That is, k is calculated as follows.

[Math. 2]

$$k \approx \frac{V}{T_x - T_0} = \frac{5A}{190 - 150} = 0.125 * A$$

Here, since the unit volume A is a known value, k is calculated as a specific value. Note that, for example, k can also be calculated by substituting another amount and another detection temperature such as the detection temperature Tx = approximately 166°C at the amount V = 2A. In any of these cases, k is calculated as substantially the same value. In this way, the value of k varies depending on the joining conditions during the preparation of a container and other conditions such as members to be adopted, but the specific value of k can be obtained by conducting such verification.

As can be seen from these results, in the case where the relationship between the amount of the detection temperature is linear, by acquiring two pieces of information, i.e., the initial temperature at the initial amount and the detection temperature at a certain amount, it is possible to calculate the amount corresponding to any subsequent detection temperature.

Note that in this example, for example, the value of $T_0$ is set to 100°C or more. By heating the plasma raw material 1 such that the initial temperature $T_0$ detected by the temperature sensor 46 is 100°C or more, it is possible to ensure that the plasma raw material 1 is in a molten state. Further, for example, the difference between the value of $T_x$ and the value of $T_0$ is set to 100°C or less. Similarly also in this case, it is possible to ensure that the plasma raw material 1 is in a molten state. It goes without saying that the specific values of $T_x$ and $T_0$ are not limited thereto.

The calculation unit 51 calculates the amount of the plasma raw material 1 using (Math. 1). Specifically, the temperature detected by the temperature sensor 46 is acquired by the communication unit of the information processing apparatus 48. The calculation unit 51 calculates the amount of the plasma raw material 1 by substituting the acquired temperature into (Math. 1).

Note that although the volume is calculated as the amount of the plasma raw material 1 in this example, the type of amount to be calculated is not limited thereto. For example, the calculation unit 51 may calculate the height of the surface (liquid level height) of the plasma raw material 1 contained in the storage section 54. For example, the liquid level height can be calculated by multiplying the calculated volume by a predetermined coefficient that depends on the shape of the storage section 54. Alternatively, the mass may be calculated. In this case, the mass can be calculated by multiplying the calculated volume by the density of the plasma raw material 1. In addition, an arbitrary amount may be calculated.

In this way, the calculation unit 51 calculates the amount of the plasma raw material 1 on the basis of the difference between a predetermined initial temperature and the temperature detected by the temperature sensor 46. The calculation using (Math. 1) is included in the calculation based on the difference. The present invention is not limited thereto, and the amount of the plasma raw material 1 may be calculated by an arbitrary calculation method based on a difference. For example, another formula including a difference other than (Math. 1) may be used.

Further, the calculation unit 51 calculates the amount of the plasma raw material 1 on the basis of the temperature detected by the temperature sensor 46. The calculation based on a difference and the calculation using (Math. 1) are included in the calculating based on the detected temperature. The present invention is not limited thereto, and the amount of the plasma raw material 1 may be calculated by an arbitrary calculation method based on the detected temperature.

For example, the calculation unit 51 may calculate the amount of the plasma raw material 1 on the basis of the temperature detected by the temperature sensor 46 and a predetermined correspondence between the temperature and the amount of the plasma raw material 1. Specifically, the correspondences between respective detection temperatures and the amounts are recorded in advance before the light source apparatus 100 is used (e.g., during production). For example, respective correspondences are obtained by actually conducting experiments using the storage section 40, and a group of correspondences is generated as a chart as shown in Fig. 5. The generated chart is, for example, stored in the storage unit of the information processing apparatus 48 and read during calculation in the calculation unit 51. Note that the correspondence may be obtained by a simulation instead of the actual experiment.

Alternatively, a group of correspondences may be generated in another format such as a table. Further, the number of correspondences to be used is also not limited. For example, the correspondence may be generated at arbitrary grid interval such as every 1°C and every 5°C. Further, the correspondence may be defined by interpolation.

As described above, in the light source apparatus 100 according to this embodiment, a temperature sensor is disposed on the surface of the side portion 44 of the storage section 40 on the outer side, and the amount of the plasma raw material 1 contained in the storage section 40 is calculated on the basis of the temperature detected by the temperature sensor 46. As a result, it is possible to accurately calculate the amount of the plasma raw material 1 contained in the storage section 40.

In EUV light source apparatuses such as the light source apparatus 100, since stable EUV emission becomes difficult when the raw material runs low, it is necessary to measure the amount of the raw material in the container for supplying the raw material. In this regard, a technology in which a sensor is suspended inside a container to detect the position of the liquid surface of the raw material (hereinafter, Comparative Example) has been used.

However, in the technology according to Comparative Example, it is difficult to detect the liquid level height unless the liquid surface reaches the sensor. That is, in the case where the liquid surface is located at a position lower than the position of the sensor, it is difficult to acquire specific information about how high the liquid surface is, and all that can be known is that "it is lower than the position of the sensor".

Although described below, the present technology is also applicable to the container in the raw material supply device 30 in Fig. 2 and the raw material container 21. That is, the present technology is also applicable to not only the container for storing the used raw material, such as the storage section 40 described above, but also a container for supplying the raw material. That is, even in the case where the liquid surface is located below the temperature sensor in the container for supplying the raw material, the specific height of the liquid surface can be known.

In the case where the specific height of the liquid surface is unknown, it is unclear when to replenish the raw material, and the container is suddenly found to be empty, occasionally interfering with the operation of the light source apparatus 100. That is, such a situation can occur in the technology according to Comparative Example. On the other hand, in the present technology, since the liquid level height can be constantly known, it is possible to replenish the raw material at appropriate timing. Note that in the case where the liquid surface is above the temperature sensor 46, information that "the liquid surface is above the temperature sensor 46" can be acquired although specific height of the liquid surface is unknown.

Further, in the case of Comparative Example, it is unclear when to dispose of the raw material in the container for storing the used raw material, and the container is suddenly found to be full, leading to overflow of the raw material from the container. In the present technology, since the liquid level height is constantly known, it is possible to dispose at appropriate timing and prevent such a situation from occurring. As described above, in the present technology, it is possible to perform scheduling of supplying and disposing of the raw material as appropriate.

Further, in the technology according to Comparative Example, sensing is performed by the sensor directly touching the raw material. Therefore, the sensor comes into contact with the high-temperature molten raw material, causing deterioration. This leads to problems such as a shortened service life of the sensor. Further, contaminants generated from impurities are floating on the liquid surface and adhere to the tip of the sensor. This results in malfunctions such as an undetected amount and erroneous detection. On the other hand, in the present technology, the temperature sensor does not come into contact with the raw material. Therefore, no special treatment for imparting heat resistance and corrosion resistance (e.g., coating or use of special materials) is necessary, reducing the production cost of the apparatus.

Further, in the technology according to Comparative Example, a sensor and a transmission line from transmitting signals of the sensor to the outside are disposed in the container. Therefore, it is necessary to provide a space for disposing the sensor itself and the transmission line in the container, leading to problems such as an increase in size of the container. On the other hand, in the present technology, since the temperature sensor and the transmission line are disposed outside the container, it is unnecessary to provide such a disposition space in the container and it is possible to miniaturize the container.

Further, in the technology according to Comparative Example, it is necessary to provide an electrical access port that communicates with the outside in order to extract the signal from the sensor to the outside. However, heat in the container escapes from this portion, degrading the heat retention of the container. Further, since that portion is a portion that comes into contact with the outside air, the temperature difference is large, easily causing deterioration. This results in malfunctions such as leakage of the outside air due to deformation or cracking. On the other hand, in the present technology, since the temperature sensor is disposed outside the container, it is unnecessary to provide an access port and it is possible to maintain the high heat retention. Further, it is possible to prevent deterioration, deformation, and the like.

Further, in this embodiment, the amount of the plasma raw material 1 is calculated on the basis of the difference between the predetermined initial temperature and the temperature detected by the temperature sensor 46. As a result, it is possible to more accurately calculate the amount.

Further, in this embodiment, the amount of the plasma raw material 1 is calculated on the basis of (Math. 1). Therefore, by acquiring two pieces of information, i.e., the initial temperature at the initial amount and the detection temperature at a certain amount, it is possible to calculate the amount corresponding to any subsequent detection temperature. That is, it is possible to simplify the pre-measurement.

Further, in this embodiment, the amount is calculated on the basis of the predetermined correspondence between the detection temperature and the amount. This allows the amount to be accurately calculated even in the case where the relationship between the detection temperature and the amount is non-linear.

Further, in this embodiment, the liquid level height of the plasma raw material 1 is calculated as the amount of the plasma raw material 1. This allows the amount of the plasma raw material 1 to be grasped intuitively.

Further, in this embodiment, the temperature sensor 46 is disposed above the center of the storage section 40. In the present technology, even in the case where the liquid surface is located below the temperature sensor 46, it is possible to calculate the specific amount of the plasma raw material 1. Therefore, by disposing the temperature sensor 46 on the upper side, the range within which the specific amount can be calculated is expanded, and the amount is more accurately calculated.

Further, in this embodiment, the heater 47 is disposed at the bottom portion 45 of the storage section 40. Since the evaporated plasma raw material 1 is accumulated in the storage section 40 through gravitational fall, the plasma raw material 1 is accumulated on the bottom portion 45 first. By disposing the heater 47 at the bottom portion 45, it is possible to ensure that the plasma raw material 1 is heated even at the initial stage of the accumulation. Further, by disposing the heater 47 on the entire surface of the bottom portion 45, it is possible to achieve an even higher heating effect.

<Second embodiment>

A more detailed embodiment of the light source apparatus 100 according to the present technology will be described as a second embodiment. In the following description, the description will be omitted or simplified for the parts similar to the configuration and effect of the light source apparatus 100 described in the above embodiment.

[Double structure]

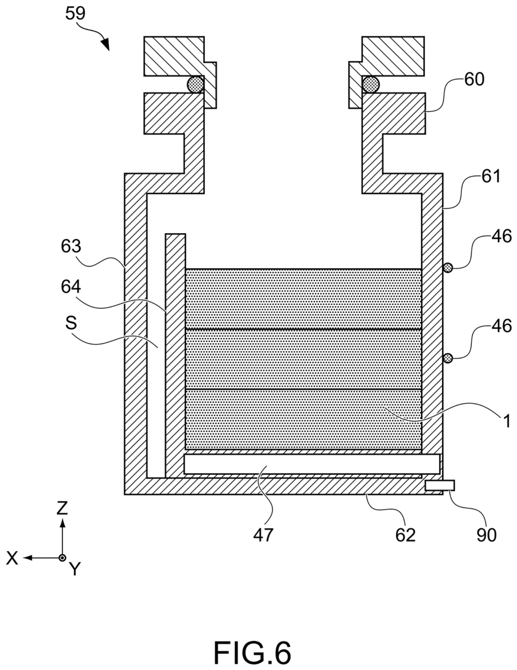

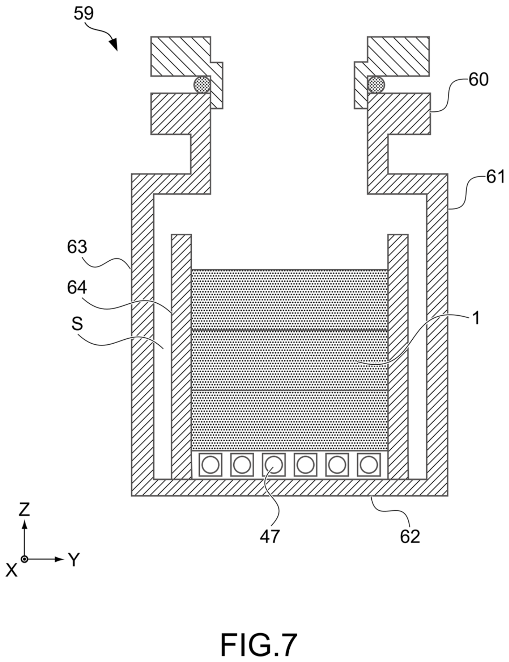

Fig. 6 and Fig. 7 are each a schematic diagram illustrating a configuration example of a storage section 59 having a double structure. Fig. 6 shows a diagram of the cross section of the storage section 59 cut through its center by the XZ plane, as viewed from the positive side of the Y direction, similarly to Fig. 3. Fig. 7 shows a diagram of the storage section 59 cut through its center by the YZ plane, as viewed from the positive side of the X direction. The storage section 59 has substantially the same shape as that of the storage section 40 in Fig. 3, and includes an upper portion 60, a side portion 61, and a bottom portion 62. Further, in this example, two temperature sensors 46 are disposed on the right side in Fig. 6.

In this example, the side portion 61 has a double structure including an outer member 63, an inner member 64, and an internal space S formed between the outer member 63 and the inner member 64. Most of the side portion 61 of the storage section 59 has a double structure as in the storage section 54 in Fig. 4, and only a strip-shaped portion where the temperature sensor 46 is disposed has a normal structure. This portion corresponds to the portion on the right side in Fig. 6.

The other portions (on the left side in Fig. 6 and on the left side and right side in Fig. 7) have a double structure. For example, on the left side in Fig. 6, the outer member 63 is disposed on the outer side (left side), the inner member 64 is disposed on the inner side (right side), and the internal space S is formed therebetween.

This allows dissipating heat of the entire storage section 59 to be reduced while facilitating heat conduction to the temperature sensor 46. For example, in the case where the entire side portion 61 has a normal structure made of a member having a high thermal conductivity, heat conduction to the temperature sensor 46 easily occurs, but the heat dissipation characteristics of the entire side portion 61 become very high, requiring a significant amount of energy to maintain the temperature of the plasma raw material 1. By making the necessary portion (portion where the temperature sensor 46 is disposed) have a normal structure and the other portions have a double structure as in this example, it is possible to facilitate heat conduction to the temperature sensor 46 and minimize the heat dissipation of the entire side portion 61.

This configuration is particularly effective when a material having high heat dissipation characteristics (e.g., SUS, iron, aluminum, or copper) has to be used for the side portion 61. As a result, it is also possible to select, for example, a material having high heat dissipation characteristics despite low density, and reduce the weight of the apparatus.

Further, in this example, the internal space S becomes a vacuum when the light source apparatus 100 is driven. It is also possible to reduce dissipating heat by filling the internal space S with a fibrous material having a large amount of space where no material exists, such as a porous material and steel wool having a poor thermal conductivity.

Further, in this example, the internal space S communicates with the inside of the storage section 59 at its upper side. For example, the upper side of the internal space S is open on the left side of Fig. 6, and communicates with the space where the plasma raw material 1 of the storage section 59 is present and the space within the chamber body 9.

In the storage section 59, the liquid level height is constantly grasped by the detection result of the temperature sensor 46 and the plasma raw material 1 is disposed at appropriate timing. Therefore, basically, the plasma raw material 1 does not overflow. However, the liquid level height cannot be detected due to malfunctions of the apparatus, or the like, and the plasma raw material 1 can overflow in some cases. In such a case, the overflowing plasma raw material 1 enters the internal space S from above in this example. As a result, the internal space S is filled with the plasma raw material 1, and the heat from the heater 47 is transferred to the side portion 61 and the outer member 63. This causes the temperature of the temperature sensor 46 to rise sharply, enabling detection of the overflowing state of the plasma raw material 1.

It goes without saying that a configuration in which the upper side of the internal space S is not open and the internal space S does not communicate with the inside of the storage section 59 may be adopted. In addition, the configuration such as the specific shapes of the outer member 63, the inner member 64, and the internal space S is not limited.

[Structure with partially different material]

As described above, in this example, the side portion 61 includes a first member and a second member having a thermal conductivity higher than that of the first member. Further, the temperature sensor 46 is disposed on the second member. Here, the portion having a double structure (the outer member 63, and the inner member 64) corresponds to the first member according to the present technology, and the portion having a normal structure corresponds to the second member. In fact, the portion having a normal structure has a thermal conductivity higher than that of the portion having a double structure. Further, the temperature sensor 46 is disposed on the portion having a normal structure.

The present invention is not limited thereto. For example, the first member may be a member made of a certain material, and the second member may be a member made of a material having a thermal conductivity higher than that of the first member. That is, a difference in thermal conductivity may be created by a difference in materials instead of creating a difference in thermal conductivity by a difference in structures such as a normal structure and a double structure. This allows the heat dissipation of the entire side portion 61 to be minimized while facilitating heat conduction to the temperature sensor 46, similarly. Alternatively, a difference in thermal conductivity may be created by a difference in thicknesses of the side portion 61. In addition, the side portion 61 may include an arbitrary number of members having different thermal conductivities.

<Third embodiment>

[Raw material container]

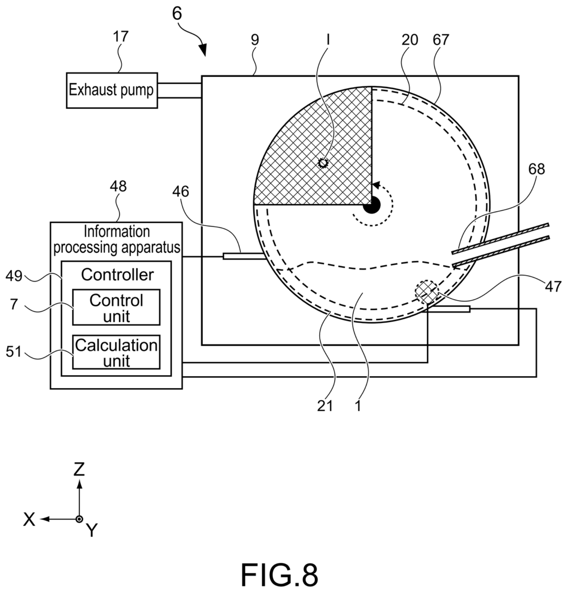

Fig. 8 is a schematic diagram illustrating a configuration example of the plasma generation mechanism 6. Fig. 8 illustrates a detailed configuration of the plasma generation mechanism 6 shown in Fig. 2. In this example, the rotation body 20 is immersed in the plasma raw material 1 contained in the raw material container 21. The raw material container 21 has a hollow disc shape and contains the plasma raw material 1 inside. The rotation body 20 has a disc shape slightly smaller than the raw material container 21, and the lower portion thereof is immersed in the plasma raw material 1 in the raw material container 21. Fig. 8 illustrates the raw material container 21, the rotation body 20, and the plasma raw material 1 by broken lines. By using such a configuration in which the rotation body 20 is immersed as an LPP light source apparatus, it is possible to generate the radiation R efficiently.

The raw material container 21 corresponds to an embodiment of the storage unit according to the present technology.

Further, the plasma generation mechanism 6 includes a cover structure 67. The cover structure 67 has a disc shape slightly larger than the raw material container 21, and houses the raw material container 21 and the rotation body 20 inside.

Further, a pipe 68 is provided to the side portion of the cover structure 67 on the right side. The pipe 68 is a pipe for supplying the plasma raw material 1 to the raw material container 21. The pipe 68 is provided, for example, at a position above the liquid surface assumed during use. The opening at the tip of the pipe 68 corresponds to an embodiment of the supply port according to the present technology.

Further, in the present technology, the temperature sensor 46 is disposed at the same height as or above the tip of the pipe 68. In this example, the temperature sensor 46 is disposed at substantially the same height as the tip of the pipe 68, on the left side surface of the cover structure 67. The present invention is not limited thereto, and the temperature sensor 46 may be disposed at a higher position such as the upper half of the cover structure 67. This makes it less likely for the liquid surface to rise above the temperature sensor 46, and allows the liquid level height to be accurately calculated.

Further, in the present technology, the heater 47 is disposed at the same height as or below the tip of the pipe 68. In this example, the heater 47 is disposed at approximately the 5 o'clock position, of the side portion of the cover structure 67. The present invention is not limited thereto, and the heater 47 may be disposed at the lowest portion (the 6 o'clock position). This allows the plasma raw material 1 to be heated efficiently and makes it less likely for the plasma raw material 1 to solidify due to insufficient heating, for example.

[Disposition variations]

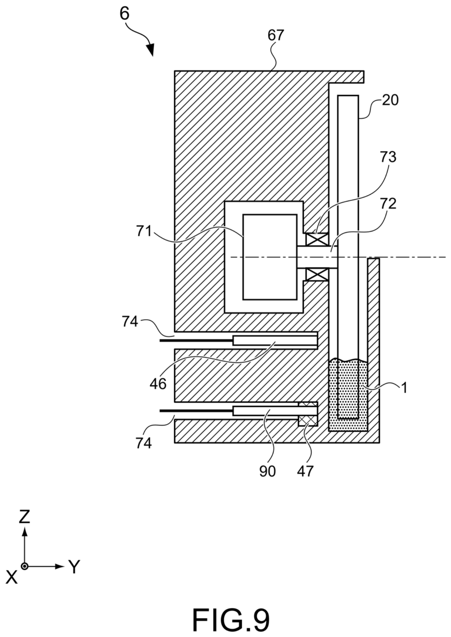

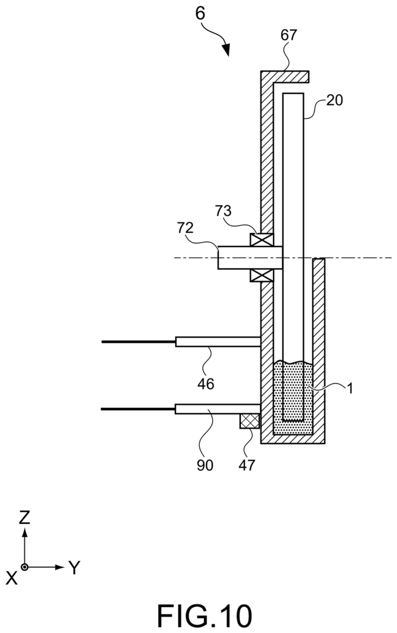

Fig. 9 and Fig. 10 are each a schematic diagram illustrating variations in the disposition of the temperature sensor 46 and the heater 47. Fig. 9 and Fig. 10 each illustrate the cross section of the plasma generation mechanism 6 in Fig. 8 cut through its center in the right-and-left direction by the YZ plane, as viewed from the positive side of the X direction. Note that the illustration of the chamber body 9 and the like is omitted.

In the example shown in Fig. 9, a space is provided inside the cover structure 67, and a motor 71 is disposed in the space. Further, an opening for communicating with this space and the outside (space on the right side) is provided to the cover structure 67. A rod-shaped shaft member 72 is disposed in the opening, and the motor 71 and the center of the back surface (left surface) of the rotation body 20 are respectively connected to the left side and right side of the shaft member 72. The control unit 7 controls the driving of the motor 71, thereby realizing the rotation of the rotation body 20. Note that a mechanical seal 73 is provided between the opening and the shaft member 72. This allows the rotation body 20 to rotate smoothly.

The rear surface (left surface) of the cover structure 67 is provided with two upper and lower insertion ports 74, and the temperature sensor 46 is inserted into the upper insertion port 74. That is, the temperature sensor 46 was disposed on the side surface of the cover structure 67 in Fig. 8, but it is disposed on the rear surface in this example. The tip of the temperature sensor 46 on the right side faces, via the cover structure 67, the space where the plasma raw material 1 is present. Similarly, the heater 47 is disposed at the right end of the lower insertion port 74. That is, the heater 47 is also disposed on the rear surface.

This allows the temperature sensor 46 and the heater 47 to be stably disposed. Further, in the case where the rear surface of the cover structure 67 includes a thick member as in this example, the portion where the motor 71 is not disposed, i.e., the unused portion, can be effectively utilized as a space for disposing the temperature sensor 46 and the heater 47. This realizes miniaturization of the apparatus.

In the example of Fig. 10, the rear surface of the cover structure 67 is not thick unlike Fig. 9, the temperature sensor 46 and the heater 47 are disposed on the rear surface similarly. For example, such disposition in this example may be adopted in the case where it is not possible to dispose the temperature sensor 46 and the heater 47 on the side surface due to space limitations. In addition, for example, the temperature sensor 46 and the heater 47 may be disposed on the surface (right surface) of the cover structure 67.

Other variations in disposition of the temperature sensor 46 and the heater 47 will be described. The temperature sensor 46 may be disposed above the heater 47. Fig. 3 and Fig. 8 correspond to this case. For example, in the case where the temperature sensor 46 is disposed above the assumed liquid surface, if the heater 47 is further disposed above the temperature sensor 46, the plasma raw material 1 is not present near the heater 47 and the heat is difficult to transfer to the plasma raw material 1. By adopting the above configuration, it is possible to efficiently heat the plasma raw material 1.

Further, the temperature sensor 46 may be disposed at the upper end of the side portion 44 of the storage section 40. That is, the temperature sensor 46 may be disposed at a position where the upper end of the side portion 44 abuts on the lower surface of the upper portion 43 in Fig. 3. This ensures that the liquid surface is located below the temperature sensor 46 in any cases, and the liquid level height can be accurately calculated.

Further, the heater 47 may be disposed below the center of the storage section 40. The examples of Fig. 3 and Fig. 8 correspond to this case. That is, the case where the heater 47 is disposed at the bottom portion as in Fig. 3 is also included in the case where it is disposed below the center. In addition, for example, the heater 47 may be disposed to be wrapped around the side portion 44 at a position below the center of the storage section 40. This allows the plasma raw material 1 to be heated more efficiently.

Note that in the examples shown in Figs. 6 and 7, 6 heaters 47 are arranged in the Y direction so as to extend along the X direction, and all of the heaters 47 are disposed to be embedded in the bottom portion 62. Such a case where the heater 47 is embedded in the bottom portion 62 is also included in the case where the heater 47 is disposed at the bottom portion 62. This allows the plasma raw material 1 to be heated more efficiently. Alternatively, an immersion heater 47 may be used. In addition, the specific disposition of the temperature sensor 46 and the heater 47 is not limited.

<Fourth embodiment>

[Circulation system]

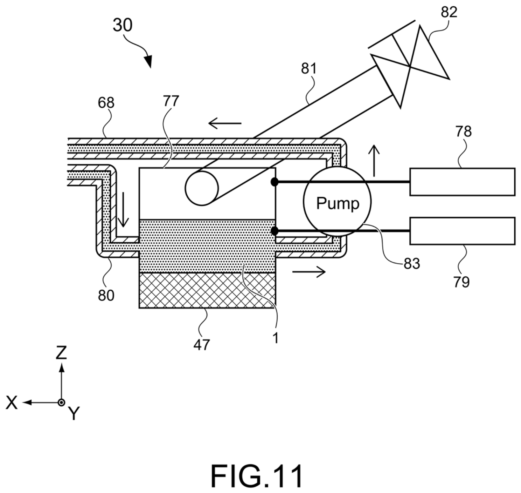

Fig. 11 is a schematic diagram illustrating a configuration example of the raw material supply device 30. Fig. 11 illustrates a detailed configuration of the raw material supply device 30 shown in Fig. 2. The raw material supply device 30 includes a storage section 77, the heater 47, two temperature sensors 78 and 79, pipes 80 and 68, a supply pipe 81, a valve 82, and a pump 83. The storage section 77 in this example also corresponds to an embodiment of the storage unit according to the present technology.

The pipe 80 is a bent pipe and has one end connected to the left lower portion of the side portion of the storage section 77. Further, the other end is connected to the right side surface of the raw material container 21 in Fig. 2. This allows the plasma raw material 1 to flow in from the outside of the storage section 77 (the raw material container 21) through the inside of the pipe 80. In Fig. 11, the orientation in which the plasma raw material 1 flows is schematically illustrated by arrows.

The pipe 80 corresponds to an embodiment of the first pipe according to the present technology.

The pipe 68 is also a bent pipe and has one end connected to the right lower portion of the side portion of the storage section 77. Further, the other end is connected to the right side surface of the raw material container 21 in Fig. 2. This allows the plasma raw material 1 to flow out to the raw material container 21 through the inside of the pipe 68.

The pipe 68 corresponds to an embodiment of the second pipe according to the present technology.

The supply pipe 81 is, for example, a straight pipe and is inserted from above the storage section 77 such that its one end (opening) faces the liquid surface of the plasma raw material 1. The supply pipe 81 supplies the plasma raw material 1 to the storage section 77.

The supply pipe 81 corresponds to an embodiment of the third pipe according to the present technology.

In addition, the diameters and the specific shapes of the pipes 80 and 68 and the supply pipe 81 are not limited. For example, the pipes 80 and 68 may be straight, and the supply pipe 81 may be bent.

In the present technology, at least one of the pipe 80, the pipe 68, or the supply pipe 81 includes a pump for causing the plasma raw material 1 to move. In this example, only the pipe 68 includes the pump 83. The pump 83 may be any type of pump and is disposed midway along the pipe 68.

The pump 83 causes the plasma raw material 1 to move. That is, when the pump 83 is driven, the plasma raw material 1 flows inside the pipes 80 and 68, realizing the inflow and outflow of the plasma raw material 1 to/from the storage section 77 and the raw material container 21. Note that the driving of the pump 83 is controlled by the control unit 7. Conversely, when the driving of the pump 83 is stopped, the inflow and outflow of the plasma raw material 1 to/from the storage section 77 are stopped. Further, the drive ratio (the flow rate of the plasma raw material 1) of the pump 83, and the like are also controlled.

In addition, for example, the pipe 80 or the supply pipe 81 may include the pump 83. Alternatively, all of the pipes 80 and 68 and the supply pipe 81 may include the pump 83. Such a configuration for circulating the plasma raw material 1 is generally referred to as a circulation system in some cases.

Further, the supply pipe 81 includes the valve 82. The valve 82 may be an arbitrary type of valve, such as a gate valve. The valve 82 controls the movement of the plasma raw material 1. That is, when the control unit 7 control opening/closing of the valve 82, the flowing of the plasma raw material 1 inside the supply pipe 81 is controlled, thereby controlling the presence or absence of supply of the plasma raw material 1 to the storage section 77. The supply rate of the plasma raw material 1 may be controlled by controlling the degree of opening of the valve 82.

The temperature sensor 78 is disposed on the upper side of the right side portion of the storage section 77. Further, the temperature sensor 79 is disposed on the lower side of the right side portion of the storage section 77. That is, in this example, the amount of the plasma raw material 1 is calculated on the basis of the detection temperature of the temperature sensor 78, and simultaneously, the amount is calculated on the basis of the detection temperature of the temperature sensor 79. In this case, for example, processing of calculating the average value of the two amounts as the final amount may be performed. This allows the amount to be calculated more accurately. This method is particularly effective because some error can occur due to linear approximation in the case where the amount is calculated using (Math. 1).

Further, the upper temperature sensor 78 may be used for determining the upper limit, and the lower temperature sensor 79 may be used for determining supply. Specifically, in the case where the liquid surface reaches the upper temperature sensor 78, it is determined that the plasma raw material 1 may overflow, and a notification indicating that the supply should be stopped is made. Alternatively, the control unit 7 may control the operation of the storage section 77 to automatically stop the supply. Further, the determination may be made when the liquid surface approaches the temperature sensor 78 to a certain extent, rather than when the liquid surface reaches the temperature sensor 78.

Further, in the case where the liquid surface drops to the lower temperature sensor 79, it is determined that the plasma raw material 1 may be insufficient, and a notification indicating that supply should be performed is made. Similarly in this case, the control unit 7 may control the operation of the valve 82 of the supply pipe 81 to perform supply automatically. Alternatively, the determination may be made when the liquid surface has passed the position of the temperature sensor 79 and then dropped to a certain extent. In this way, it is possible to grasp the timing of supplying the plasma raw material 1 more properly.

As described above, in the present technology, a plurality of temperature sensors is disposed as temperature sensors. Although the two temperature sensors 78 and 79 are disposed in this example, three or more temperature sensors may be disposed. This allows the amount of the plasma raw material 1 to be calculated more accurately. Further, the specific disposition of each temperature sensor is also not limited. A plurality of temperature sensors may be disposed the storage section 40 or the raw material container 21 in Fig. 2.

Similarly, a plurality of heaters 47 may be disposed in the storage sections 40 and 77 and the raw material container 21. This allows the plasma raw material 1 to be heated more efficiently. Alternatively, the heater 47 may be disposed on the pipe 68 or 80 or the supply pipe 81. For example, the heater 47 may be disposed to be wrapped around the pipe 68.

Further, the temperature sensors 78 and 79 may detect the temperature while the flow of the plasma raw material 1 in the storage section 77 is stopped. Specifically, for example, the control unit 7 performs control such that the valve 82 is closed and the driving of the pump 83 is stopped, the flow of the plasma raw material 1 in the storage section 77 is completely stopped. Then, an instruction to detect a temperature is transmitted from the control unit 7 to the temperature sensors 78 and 79, and the temperature of the plasma raw material 1 in the stationary state is detected. In this way, the temperature is detected while the heat transfer in the plasma raw material 1 is suppressed, and thus, it is possible to calculate the amount more accurately. In addition, the specific method of detecting the temperature while the flow of the plasma raw material 1 is stopped is not limited.

<Fifth embodiment>

[Raw material recycling]

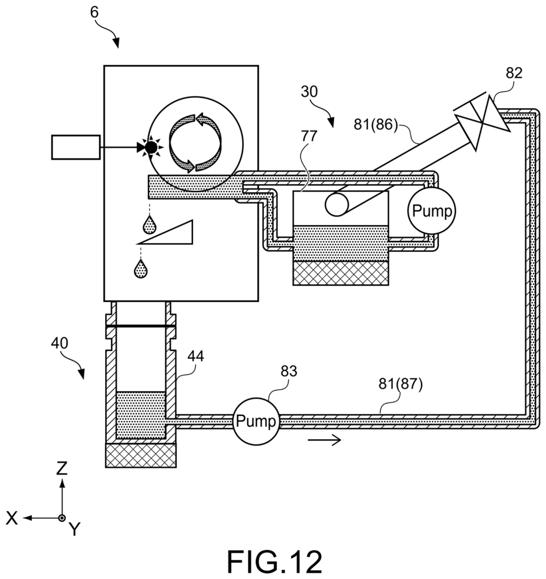

Fig. 12 is a schematic diagram illustrating a configuration example of the plasma generation mechanism 6 capable of recycling the plasma raw material 1. In this example, the supply pipe 81 includes a tip portion 86 (on the left side of the valve 82) and a pipe section 87 (on the right side and lower side of the valve 82). One end of the pipe section 87 is connected to the right side of the side portion 44 of the storage section 40, and the other end is connected to the valve 82.

The storage section 40 corresponds to an embodiment of another storage section different from the storage section 77 according to the present technology.

Further, the pipe section 87 is provided with the pump 83. When the valve 82 is opened and the pump 83 is driven, the plasma raw material 1 flows inside the pipe section 87, and the plasma raw material moves from the storage section 40 to the storage section 77.

The plasma raw material 1 accumulated in the storage section 40 includes a scattered plasma raw material and the like, and can be reused in some cases. In this case, manually transferring the plasma raw material 1 from the storage section 40 to the storage section 77 is also conceivable, but this is labor-intensive. Adopting the configuration in this example allows the plasma raw material 1 to automatically move from the storage section 40 to the storage section 77, reducing the labor required for reuse. Note that not only the example shown in Fig. 11 but also the system in this example is generally referred to as a circulation system in some cases.

<Sixth embodiment>

[Heater-side temperature sensor]

A temperature sensor may be disposed on the heater side and the temperature of the plasma raw material 1 may be maintained at a predetermined temperature by heating the plasma raw material 1 by the heater 47 on the basis of the temperature detected by the heater-side temperature sensor.

In the examples of Figs. 6, 9, and 10, a temperature sensor 90 is disposed in the vicinity of the heater 47 as a heater-side temperature sensor. In this example, the temperature sensor 90 detects a temperature and the control unit 7 acquires the detection temperature. In the case where the detection temperature is lower than a predetermined temperature, the driving is controlled to increase the output of the heater 47. Conversely, in the case where the detection temperature is higher than the predetermined temperature, the driving is controlled to decrease the output of the heater 47. That is, the heater 47 is driven such that the temperature of the plasma raw material 1 is fed back to the heater 47.

This allows the temperature of the plasma raw material 1 to be maintained accurately and prevents, for example, the plasma raw material 1 from solidifying due to the temperature drop. It goes without saying that a configuration in which the temperature sensor 90 is not disposed and the heater 47 performs heating at a constant output may be adopted.

The heater 47 corresponds to an embodiment of the heating mechanism according to the present technology.

The temperature sensor 90 corresponds to an embodiment of the second temperature sensor according to the present technology.

The heater 47 and the temperature sensor 90 correspond to an embodiment of the temperature adjustment mechanism according to the present technology.

In particular, in the example of Fig. 10, the temperature sensor 90 is disposed below the liquid surface together with the heater 47. Therefore, the liquid surface is located above the temperature sensor 90, the specific amount of the plasma raw material 1 is difficult to calculate. That is, the temperature sensor 90 is used to only control the heater 47.

In addition, the specific disposition of the temperature sensor 90 is not limited. For example, in the case where a plurality of heaters 47 is disposed, one temperature sensor 90 may be disposed for each heater 47. Alternatively, a plurality of temperature sensors 90 may be disposed for one heater 47.

<Other embodiments>

The present technology is not limited to the embodiments described above, and various other embodiments can be realized.

[Type of plasma raw material]

As the plasma raw material 1, tin, lithium, gadolinium, gallium, bismuth, indium, or an alloy including at least one of these materials can be used. For example, in the case where EUV light is extracted as the radiation R and the EUV light is used for a microscope, bismuth is used as the material. Further, in the case where X-rays are generated as the radiation R, indium is used as the material. By using these materials, it is possible to generate the high-quality radiation R. In addition, the specific type of plasma raw material 1 is not limited.

Further, the plasma raw material 1 does not necessarily need to be a liquid raw material, and the plasma raw material 1 in an arbitrary form such as a powder and a solution power material including a powder may be used. Further, the present technology is also appliable to the case where contents contained in the storage section 40 are not a raw material.

[Configuration of container]

The side portion 44 of the storage section 40 is made of, for example, ceramics, stainless steel, or silicon. In addition, each member of the storage section 40 may be made of an arbitrary material. For example, in the case where the plasma raw material 1 is corrosive, the storage section 40 may be made of a material having corrosion resistance. Alternatively, the inner wall may be subjected to corrosion-resistant coating. This allows an inexpensive material to be selected. Further, the side portion 44 is formed to have, for example, a thickness of 1 mm or more and 20 mm or less. Alternatively, it is formed to have a thermal conductivity of 10 W/(m×k) or more and 200 W/(m×k) or less at 300 K. In this way, it is possible to calculate the amount of the plasma raw material 1 more accurately.

[Applications to other apparatuses]

Although a case where the present technology is applied to an LPP light source apparatus has been described in this example, the present invention is not limited thereto. The present technology may be applied to a DPP or LDP light source apparatus. Alternatively, the present technology may be applied to a container for a raw material, which is used in an apparatus other than the light source apparatus.

[Configuration of information processing apparatus]

The communication unit included in the information processing apparatus 48 may transmit the calculated amount and the detected temperature to the outside. Further, the amount and the detection temperature may be stored in the storage unit. Further, the information processing apparatus 48 may include a display unit and an operation unit. The display unit is, for example, a display device using liquid crystal, electroluminescence (EL), or the like, and displays the amount, the detection temperature, various images, various graphical user interfaces (GUIs), and the like to users using the light source apparatus 100. The operation unit is, for example, a keyboard, a pointing device, a touch panel, or another operating device. In the case where the operation unit include a touch panel, the touch panel may be integrated with the display unit. The plasma raw material 1 may be supplied or disposed by operating the operation unit by a user.

The light source apparatus, the plasma generation mechanism, the plasma raw material, the rotation body, the raw material container, the raw material supply device, the storage section, the temperature sensor, the heater, the information processing apparatus, the pipe, the supply pipe, the valve, the pump, and the like described with reference to the drawings are merely an embodiment, and can be arbitrarily modified without departing from the essence of the present technology. That is, other arbitrary configurations and the like for carrying out the present technology may be employed.

In the present disclosure, in the case where the word "substantially" is used, it is used only to facilitate the understanding of description, and the use/non-use of the word "substantially" has no special meaning. That is, in the present disclosure, concepts that define shapes, sizes, position relationships, and states such as "central", "middle", "uniform", "equal", "the same", "orthogonal", "parallel", "symmetrical", "extended", "axial direction", "cubic shape", "rectangular parallelepiped shape", "cone shape", "disc shape", "polygonal shape", "cylindrical shape", "spherical shape", "prismatic shape", and "rod shape" are concepts including "substantially central", "substantially middle", "substantially uniform", "substantially equal", "substantially the same", "substantially orthogonal", "substantially parallel", "substantially symmetrical", "substantially extended", "substantially axial direction", "substantially cubic shape", "substantially rectangular parallelepiped shape", "substantially cone shape", "substantially disc shape", "substantially polygonal shape", "substantially cylindrical shape", "substantially spherical shape", "substantially prismatic shape", and "substantially rod shape". The concepts also include concepts having states in a predetermined range (e.g., $\pm 10\%$ range) with respect to, for example, "completely central", "completely middle", "completely uniform", "completely equal", "completely the same", "completely orthogonal", "completely parallel", "completely symmetrical", "completely extended", "substantially cubic shape", "substantially rectangular parallelepiped shape", "substantially cone shape", "substantially disc shape", "substantially polygonal shape", "substantially cylindrical shape", "substantially spherical shape", "substantially prismatic shape", and "substantially rod shape". Therefore, even in the case where the word "substantially" is not added, a concept expressed by adding a so-called "substantially" can be included. On the contrary, the complete state is not excluded from the state expressed by adding "substantially".

In the present disclosure, expressions using "than" such as "larger than A" and "smaller than A" are expressions comprehensively including both the concept including the case where it is equivalent to A and the concept not including the case where it is equivalent to A. For example, "greater than A" is not limited to the case where it does not include "equal to A", and it also includes "equal to or greater than A". Further, "less than A" is not limited to "less than A", and it also includes "equal to or less than A". Upon the implementation of the present technology, specific settings and other settings only need to be appropriately adopted from the concepts that are included in "greater than A" and "less than A" to achieve the effects described above.

Out of the feature parts according to the present technology described above, at least two feature parts can be combined. In other words, the various characteristic portions described in the respective embodiments may be arbitrarily combined with each other without distinguishing from each other in the respective embodiments. It should be noted that the effects described above are merely illustrative and are not limitative, and may have an additive effect.

Reference Signs List

1 plasma raw material
6 plasma generation mechanism

7 control unit
20 rotation body
21 raw material container
30 raw material supply device
40, 54, 59, 77 storage section
44, 55, 56, 61 side portion
45 bottom portion
46, 78, 79, 90 temperature sensor
47 heater
48 information processing apparatus
49 controller
51 calculation unit
63 outer member
64 inner member
68, 80 pipe
81 supply pipe
82 valve
83 pump
100 light source apparatus

**Claims**

1.  A storage device, comprising:

    a storage unit that contains contents and has a side portion;
    a first temperature sensor that is disposed on a surface of the side portion on an outer side;
    a temperature adjustment mechanism that is capable of maintaining a temperature of the contents contained in the storage unit at a predetermined temperature; and
    a calculation unit that calculates an amount of the contents contained in the storage unit on a basis of a temperature detected by the first temperature sensor.

2.  The storage device according to claim 1, wherein
    the calculation unit calculates the amount of the contents on a basis of a difference between a predetermined initial temperature and the temperature detected by the first temperature sensor.

3.  The storage device according to claim 2, wherein
    the calculation unit calculates the amount of the contents using the following formula.

    [Math 1]

    $$V = k \left( T_x - T_0 \right)$$

    V: the amount of the contents
    k: a predetermined coefficient
    $T_x$: the temperature detected by the first temperature sensor
    $T_0$: the predetermined initial temperature

4.  The storage device according to claim 3, wherein
    the $T_0$ has a value of 100°C or more.

5.  The storage device according to claim 3 or 4, wherein
    a difference between a value of the $T_x$ and a value of the $T_0$ is 100°C or less.

6.  The storage device according to claim 1, wherein
    the calculation unit calculates the amount of the contents on a basis of the temperature detected by the first temperature sensor and a predetermined correspondence between a temperature and the amount of the contents.

7. The storage device according to claim 1 or 2, wherein
the calculation unit calculates a height of a surface of the contents contained in the storage unit.

8. The storage device according to claim 1 or 2, wherein
the first temperature sensor is disposed above the temperature adjustment mechanism.

9. The storage device according to claim 1 or 2, wherein
the first temperature sensor is disposed above a center of the storage unit.

10. The storage device according to claim 9, wherein
the first temperature sensor is disposed at an upper end of the side portion of the storage unit.

11. The storage device according to claim 1 or 2, wherein
the temperature adjustment mechanism is disposed below a center of the storage unit.

12. The storage device according to claim 11, wherein

    the storage unit has a bottom portion, and
    the temperature adjustment mechanism is disposed at the bottom portion of the storage unit.

13. The storage device according to claim 1 or 2, wherein
a rotation body is immersed in the contents contained in the storage unit.

14. The storage device according to claim 13, wherein

    the storage unit is provided with a supply port for supplying the contents to the storage unit, and
    the first temperature sensor is disposed at a same height as or above the supply port.

15. The storage device according to claim 13, wherein

    the storage unit is provided with a supply port for supplying the contents to the storage unit, and
    the temperature adjustment mechanism is disposed at a same height as or below the supply port.

16. The storage device according to claim 1 or 2, wherein
the first temperature sensor includes a plurality of first temperature sensors.

17. The storage device according to claim 1 or 2, wherein

    the temperature adjustment mechanism includes a heating mechanism that heats the contents contained in the storage unit and a second temperature sensor, and
    the heating mechanism maintains the temperature of the contents at a predetermined temperature by heating the contents on a basis of a temperature detected by the second temperature sensor.

18. The storage device according to claim 17, wherein
the second temperature sensor is disposed above the heating mechanism.

19. The storage device according to claim 1 or 2, wherein
a first pipe for causing the contents to flow from an outside thereinto and a second pipe for causing the contents to flow out to the outside are connected to the storage unit, and a third pipe for supplying the contents to the storage unit is inserted into the storage unit from above.

20. The storage device according to claim 19, wherein

    the third pipe includes a valve that controls movement of the contents, and
    another storage unit is connected to the third pipe.

21. The storage device according to claim 19, wherein
at least one of the first pipe, the second pipe, or the third pipe includes a pump for causing the contents to move.

**22.** The storage device according to claim 1 or 2, wherein
the side portion is formed of ceramics, stainless steel, or silicon.

**23.** The storage device according to claim 1 or 2, wherein
the side portion has a thickness of 1 mm or more and 20 mm or less.

**24.** The storage device according to claim 1 or 2, wherein
the side portion has a thermal conductivity of 10 W/(m×k) or more and 200 W/(m×k) or less at 300 K.

**25.** The storage device according to claim 1 or 2, wherein

the side portion includes a first member and a second member having a thermal conductivity higher than that of the first member, and
the first temperature sensor is disposed in the second member.

**26.** The storage device according to claim 1 or 2, wherein
the side portion has a double structure including an outer member, an inner member, and an internal space formed between the outer member and the inner member.

**27.** The storage device according to claim 26, wherein
the internal space communicates with an inside of the storage unit at its top.

**28.** The storage device according to claim 1 or 2, wherein
the contents include a liquid raw material.

**29.** The storage device according to claim 28, wherein
the liquid raw material is tin, lithium, gadolinium, gallium, bismuth, indium, or an alloy including at least one of these materials.

**30.** The storage device according to claim 1 or 2, wherein
the contents include a powder raw material.

**31.** A content amount calculation method, comprising:

calculating, in a storage device that includes

a storage unit that contains contents and has a side portion,
a first temperature sensor that is disposed on a surface of the side portion on an outer side, and
a temperature adjustment mechanism that is capable of maintaining a temperature of the contents contained in the storage unit at a predetermined temperature,

an amount of the contents contained in the storage unit on a basis of a temperature detected by the first temperature sensor.

**32.** The content amount calculation method according to claim 31, further comprising
detecting, by the first temperature sensor, the temperature while a flow of the contents inside the storage unit is stopped.

**33.** A light source apparatus that generates radiation by converting a raw material into plasma utilizing application of an energy beam, comprising:
a storage device that includes

a storage unit that contains the raw material and has a side portion,
a first temperature sensor that is disposed on a surface of the side portion on an outer side,
a temperature adjustment mechanism that is capable of maintaining a temperature of the raw material contained in the storage unit at a predetermined temperature, and
a calculation unit that calculates an amount of the raw material contained in the storage unit on a basis of a temperature detected by the first temperature sensor.

FIG.1

EP 4 711 851 A1

FIG.2

24

9

43

46

44

48

Information
processing apparatus

49

Controller

7

Control
unit

51

Calculation
unit

1

40

45

47

Z

X

Y

FIG.3

FIG.4

FIG.5

FIG.6

FIG.7

FIG.8

FIG.9

FIG.10

**FIG.11**

FIG.12

# EP 4 711 851 A1

## INTERNATIONAL SEARCH REPORT

| | International application No. |
|---|---|
| | **PCT/JP2024/021000** |

| A. | CLASSIFICATION OF SUBJECT MATTER |
|---|---|

*G03F 7/20*(2006.01)i; *G21G 4/04*(2006.01)i; *G21K 1/00*(2006.01)i; *G21K 5/02*(2006.01)i; *H05G 2/00*(2006.01)i
FI:   G03F7/20 503; G21G4/04; G21K1/00 X; G21K5/02 X; H05G2/00 K

According to International Patent Classification (IPC) or to both national classification and IPC

| B. | FIELDS SEARCHED |
|---|---|

Minimum documentation searched (classification system followed by classification symbols)

G03F7/20-7/24; G03F9/00-9/02; G01F23/00; G01F23/22

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2023-25817 A (USHIO ELECTRIC INC.) 24 February 2023 (2023-02-24) paragraphs [0008]-[0009], [0042]-[0043], [0069]-[0071], [0089]-[0090], fig. 1, 3 | 1-2, 6-29, 31-33 |
| A | | 3-5, 30 |
| Y | JP 3-210427 A (KABUSHIKI KAISHA TOSHIBA) 13 September 1991 (1991-09-13) description, p. 3, upper right column, line 1 to p. 4, upper right column, line 6, fig. 1-3 | 1-2, 6-29, 31-33 |
| A | | 3-5, 30 |
| Y | US 9772210 B1 (HOUGHTON, Brian L.) 26 September 2017 (2017-09-26) description, column 4, lines 18-30, 40-60, fig. 2, 5 | 1-2, 6-29, 31-33 |
| A | | 3-5, 30 |
| Y | US 2006/0144140 A1 (HACHE, Yvon) 06 July 2006 (2006-07-06) paragraph [0034], fig. 2 | 1-2, 6-29, 31-33 |
| A | | 3-5, 30 |

| ✓ Further documents are listed in the continuation of Box C. | ✓ See patent family annex. |
|---|---|
| \* Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |
| Date of the actual completion of the international search <br><br> **01 August 2024** | Date of mailing of the international search report <br><br> **13 August 2024** |
| Name and mailing address of the ISA/JP <br><br> **Japan Patent Office (ISA/JP)** <br> **3-4-3 Kasumigaseki, Chiyoda-ku, Tokyo 100-8915** <br> **Japan** | Authorized officer <br><br><br><br> Telephone No. |

Form PCT/ISA/210 (second sheet) (July 2022)

## INTERNATIONAL SEARCH REPORT

| International application No. |
|---|
| **PCT/JP2024/021000** |

### C. DOCUMENTS CONSIDERED TO BE RELEVANT

| Category* | Citation of document, with indication, where appropriate, of the relevant passages | Relevant to claim No. |
|---|---|---|
| Y | WO 2014/054180 A1 (MITSUBISHI ELECTRIC CORPORATION) 10 April 2014 (2014-04-10) paragraph [0055], fig. 10 | 1-2, 6-29, 31-33 |
| A | | 3-5, 30 |
| Y | JP 2023-33671 A (USHIO ELECTRIC INC.) 13 March 2023 (2023-03-13) paragraph [0070], fig. 1 | 19-21 |
| A | | 1-18, 22-33 |
| Y | JP 2023-14709 A (USHIO ELECTRIC INC.) 31 January 2023 (2023-01-31) paragraph [0046], fig. 1 | 19-21 |
| A | | 1-18, 22-33 |
| Y | JP 2017-212185 A (USHIO ELECTRIC INC.) 30 November 2017 (2017-11-30) paragraph [0032], fig. 2 | 19-21 |
| A | | 1-18, 22-33 |
| A | JP 6184503 B2 (MITSUBISHI ELECTRIC CORPORATION) 23 August 2017 (2017-08-23) entire text, all drawings | 1-33 |
| A | WO 2014/118904 A1 (MITSUBISHI ELECTRIC CORPORATION) 07 August 2014 (2014-08-07) entire text, all drawings | 1-33 |
| A | JP 2015-87231 A (DENSO CORPORATION) 07 May 2015 (2015-05-07) entire text, all drawings | 1-33 |
| A | US 2013/0192352 A1 (ISANIK S.R.L.) 01 August 2013 (2013-08-01) entire text, all drawings | 1-33 |

Form PCT/ISA/210 (second sheet) (July 2022)

## INTERNATIONAL SEARCH REPORT
### Information on patent family members

International application No.

**PCT/JP2024/021000**

| Patent document cited in search report | | | Publication date (day/month/year) | Patent family member(s) | | | Publication date (day/month/year) |
|---|---|---|---|---|---|---|---|
| JP | 2023-25817 | A | 24 February 2023 | US | 2023/0049650 | A1 | |
| | | | | paragraphs [0009]-[0010], [0058]-[0059], [0086]-[0088], [0106]-[0107], fig. 1, 3 | | | |
| | | | | EP | 4135484 | A1 | |
| | | | | KR | 10-2023-0024202 | A | |
| | | | | TW | 202307580 | A | |
| JP | 3-210427 | A | 13 September 1991 | (Family: none) | | | |
| US | 9772210 | B1 | 26 September 2017 | CA | 2783779 | A1 | |
| US | 2006/0144140 | A1 | 06 July 2006 | WO | 2004/003488 | A1 | |
| | | | | CA | 2532946 | A1 | |
| WO | 2014/054180 | A1 | 10 April 2014 | US | 2015/0292932 | A1 | |
| | | | | paragraph [0090], fig. 10 | | | |
| | | | | CN | 104704329 | A | |
| JP | 2023-33671 | A | 13 March 2023 | (Family: none) | | | |
| JP | 2023-14709 | A | 31 January 2023 | US | 2023/0021544 | A1 | |
| | | | | paragraph [0052], fig. 1 | | | |
| JP | 2017-212185 | A | 30 November 2017 | US | 2019/0339620 | A1 | |
| | | | | paragraphs [0081]-[0082], fig. 2 | | | |
| | | | | WO | 2017/203988 | A1 | |
| JP | 6184503 | B2 | 23 August 2017 | US | 2016/0201964 | A1 | |
| | | | | entire text, all drawings | | | |
| | | | | WO | 2015/045129 | A1 | |
| | | | | EP | 3051235 | A1 | |
| | | | | CN | 105579795 | A | |
| WO | 2014/118904 | A1 | 07 August 2014 | GB | 2524441 | A | |
| | | | | entire text, all drawings | | | |
| JP | 2015-87231 | A | 07 May 2015 | US | 2016/0273952 | A1 | |
| | | | | EP | 3064909 | A1 | |
| | | | | TW | 201531669 | A1 | |
| | | | | KR | 10-2016-0061402 | A | |
| | | | | CN | 105683723 | A | |
| US | 2013/0192352 | A1 | 01 August 2013 | WO | 2012/020443 | A1 | |
| | | | | EP | 2603779 | A1 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014216286 A